# EUROPÄISCHE PATENTSCHRIFT

(11) **EP 1 106 040 B1**
(45) Veröffentlichungstag und Bekanntmachung des Hinweises auf die Patenterteilung: **27.03.2002**
(21) Anmeldenummer: 99934550.7
(22) Anmeldetag: 01.07.1999
(51) Int. Cl.: H05K 3/40, H01L 21/48, H01L 23/13

(54) **VERFAHREN ZUR HERSTELLUNG VON VERDRAHTUNGEN MIT ELEKTRISCH LEITENDEN QUERVERBINDUNGEN ZWISCHEN OBER- UND UNTERSEITE EINES SUBSTRATS SOWIE VERDRAHTUNG MIT DERARTIGEN QUERVERBINDUNGEN**
METHOD FOR PRODUCING INTERCONNECTIONS WITH ELECTRICALLY CONDUCTIVE CROSS CONNECTIONS BETWEEN THE TOP AND THE BOTTOM PART OF A SUBSTRATE AND INTERCONNECTIONS HAVING SUCH CROSS CONNECTIONS
PROCEDE DE PRODUCTION DE CABLES COMPRENANT DES CONNEXIONS TRANSVERSALES ELECTRIQUEMENT CONDUCTRICES ENTRE LA FACE SUPERIEURE ET LA FACE INFERIEURE D'UN SUBSTRAT ET CABLE DOTE DE TELLES CONNEXIONS TRANSVERSALES

(30) Priorität: 10.07.1998 DE 19830964
(43) Veröffentlichungstag der Anmeldung: 13.06.2001
(73) Patentinhaber: Siemens S.A., 1060 Bruxelles (BE)
(72) Erfinder: BOONE, Luc, B-8020 Oostkamp (BE); DE STEUR, Hubert, B-9031 Drongen (BE); HEERMAN, Marcel, B-9200 Merelbeke (BE); VAN PUYMBROECK, Jozef, B-8020 Oostkamp (BE)
(74) Vertreter: Berg, Peter
(86) Internationale Anmeldenummer: EP9904565
(87) Internationale Veröffentlichungsnummer: WO0003571

(56) Entgegenhaltungen:
- EP-A- 0 575 848
- EP-A- 0 645 953
- EP-A- 0 711 102
- EP-A- 0 740 497
- WO-A-96/09646
- DE-A- 3 732 249
- US-A- 4 645 732
- R.C. ANDERSON ET AL.: "Printed circuit boards with multiconductor through-holes" TECHNICAL DIGEST - WESTERN ELECTRIC, Nr. 41, Januar 1976 (1976-01), Seiten 1-2, XP002008961 NEW YORK US
- PATENT ABSTRACTS OF JAPAN vol. 96, no. 10, 31. Oktober 1996 (1996-10-31) & JP 08 148803 A (MATSUSHITA ELECTRIC WORKS), 7. Juni 1996 (1996-06-07)
- PATENT ABSTRACTS OF JAPAN vol. 12, no. 432 (M-763), 15. November 1988 (1988-11-15) & JP 63 166555 A (TOSHIBA CORP), 9. Juli 1988 (1988-07-09)

## Beschreibung

Integrierte Schaltkreise bekommen immer höhere Anschlußzahlen und werden dabei immer weiter miniaturisiert. Die bei dieser zunehmenden Miniaturisierung erwarteten Schwierigkeiten mit Lotpastenauftrag und Bestückung sollen durch neue Gehäuseformen behoben werden, wobei hier insbesondere Single-, Few- oder Multi-Chip-Module im Ball Grid Array Package hervorzuheben sind (DE-Z productronic 5, 1994, Seiten 54, 55). Diese Module basieren auf einem durchkontaktierten Substrat, auf welchem die Chips beispielsweise über Bonddrähte oder mittels Flipchip-Montage kontaktiert sind. An der Unterseite des Substrats befindet sich das Ball Grid Array (BGA), das häufig auch als Solder Grid Array oder Solder Bump Array bezeichnet wird. Das Ball Grid Array umfaßt auf der Unterseite des Substrats flächig angeordnete Lothöcker, die eine Oberflächenmontage auf den Leiterplatten oder Baugruppen ermöglichen. Durch die flächige Anordnung der Lothöcker können hohe Anschlußzahlen in einem groben Raster von beispielsweise 1,27 mm realisiert werden.

Bei der sog. MID-Technologie (MID = Moulded Interconnection Devices) werden anstelle konventioneller gedruckter Schaltungen Spritzgießteile mit integrierten Leiterzügen verwendet. Hochwertige Thermoplaste, die sich zum Spritzgießen von dreidimensionalen Substraten eignen, sind die Basis dieser Technologie. Derartige Thermoplaste zeichnen sich gegenüber herkömmlichen Substratmaterialien für gedruckte Schaltungen durch bessere mechanische, chemische, elektrische und umwelttechnische Eigenschaften aus. Bei einer speziellen Richtung der MID-Technologie, der sog. SIL-Technik (SIL = Spitzgießteile mit integrierten Leiterzügen), erfolgt die Strukturierung einer auf die Spritzgießteile aufgebrachten Metallschicht unter Verzicht auf die sonst übliche Maskentechnik durch ein spezielles Laserstrukturierungsverfahren. In die dreidimensionalen Spritzgießteile mit strukturierter Metallisierung sind dabei mehrere mechanische und elektrische Funktionen integrierbar. Die Gehäuseträgerfunktion übernimmt gleichzeitig Führungen und Schnappverbindungen, während die Metallisierungsschicht neben der Verdrahtungs- und Verbindungsfunktion auch als elektromagnetische Abschirmung dient und für eine gute Wärmeabfuhr sorgt. Zur Herstellung von elektrisch leitenden Querverbindungen zwischen zwei Verdrahtungsanlagen auf einander gegenüberliegenden Oberflächen der Spritzgußteile werden bereits beim Spritzgießen entsprechende Durchkontaktierungslöcher erzeugt. Die Innenwandungen dieser Durchkontaktierungslöcher werden dann beim Metallisieren der Spritzgießteile ebenfalls mit einer Metallschicht überzogen. Weitere Einzelheiten zur Herstellung von dreidimensionalen Spritzgießteilen mit integrierten Leiterzügen gehen beispielsweise aus der DE-A-37 32 249 oder der EP-A-0 361 192 hervor.

Gemäß einer aus der EP-A-0 645 953 bekannten Variante der MID-Technologie werden auf einem durch Spritzgießen hergestellten und mit einer Mulde versehenen Substrat nacheinander eine erste Leiterebene, eine Dielektrikumschicht und eine zweite Leiterebene erzeugt, worauf in die Mulde ein elektronisches Bauelement eingebracht wird, die Anschlüsse des Bauelements mit zugeordneten Anschlußflächen auf dem Substrat vorzugsweise durch Bonden elektrisch leitend verbunden werden und dann durch Füllen der Mulde mit Kunststoff eine Verkapselung für das Bauelement gebildet wird. Es entsteht ein kompakter, dünner Aufbau mit einer hohen Verdrahtungsdichte. Durch die versunkene Montage und Verkapselung von Bauelementen in Mulden des spritzgegossenen Substrats wird neben der Dickenreduzierung ein optimaler Schutz von Bauelement und dessen Anschlußverdrahtung erzielt.

Aus der WO-A-96 096 46 ist ein sog. Polymer Stud Grid Array (PSGA) bekannt, welches die Vorteile eines Ball Grid Arrays (BGA) mit den Vorteilen der MID-Technologie vereinigt. Die Bezeichnung der neuen Bauform als Polymer Stud Grid Array (PSGA) erfolgte dabei in Anlehnung an das Ball Grid Array (BGA), wobei der Begriff "Polymer Stud" auf beim Spritzgießen des Substrats mitgeformte Polymerhöcker hinweisen soll. Die neue für Single-, Few- oder Multi-Chip-Module geeignete Bauform umfaßt
- ein spritzgegossenes, dreidimensionales Substrat aus einem elektrisch isolierenden Polymer,
- auf der Unterseite des Substrats flächig angeordnete und beim Spritzgießen mitgeformte Polymerhöcker,
- auf den Polymerhöckem durch eine lötbare Endoberfläche gebildete Außenanschlüsse,
- zumindest auf der Unterseite des Substrats ausgebildete Leiterzüge, die die Außenanschlüsse mit Innenanschlüssen verbinden, und
- mindestens einen auf dem Substrat angeordneten Chip, dessen Anschlüsse mit den Innenanschlüssen elektrisch leitend verbunden sind.

Neben der einfachen und kostengünstigen Herstellung der Polymerhöcker beim Spritzgießen des Substrats kann auch die Herstellung der Außenanschlüsse auf den Polymerhöckern mit minimalem Aufwand zusammen mit der bei der MID-Technologie bzw. der SIL-Technik üblichen Herstellung der Leiterzüge vorgenommen werden. Durch die bei der SIL-Technik bevorzugte Laserfeinstrukturierung können die Außenanschlüsse auf den Polymerhöckern mit hohen Anschlußzahlen in einem sehr feinen Raster realisiert werden. Hervorzuheben ist ferner, daß die Temperaturausdehnung der Polymerhöcker den Temperaturausdehnungen des Substrats und der das Modul aufnehmenden Leiterplatte entspricht. Sollten mechanische Spannungen auftreten, so ermöglichen die Polymerhöcker durch ihre elastischen Eigenschaften zumindest einen teilweisen Ausgleich. Durch die Formstabilität der auf den Polymerhöckern gebildeten Außenanschlüsse kann auch die Sicherheit bei Reparatur und Austausch gegenüber den Ball Grid Arrays mit ihren durch Lothöcker gebildeten Anschlüssen erheblich gesteigert werden. Bei dem Polymer Stud Grid Array sind die Polymerhöcker und der Chip oder die Chips üblicherweise auf der gleichen Seite des Substrats angeordnet. Bei einem mit Durchkontaktierungen versehenen Substrat können die Polymerhöcker und der Chip oder die Chips durchaus auch auf verschiedenen Seiten des Substrats angeordnet sein. Eine derartige Anordnung von Polymerhöckern und Chips auf gegenüberliegenden Seiten des Substrats ist insbesondere bei großen Chips, die eine Vielzahl von zugeordneten Außenanschlüssen benötigen, interessant.

Aus der WO-A-89 00346 sind für die Oberflächenmontage geeignete Single-Chip-Module bekannt, die auf einem spritzgegossenen dreidimensionalen Substrat mit Durchkontaktierungslöchern basieren. Neben diesen Durchkontaktierungslöchern erhält das Substrat beim Spritzgießen eine zentral auf der Oberseite angeordnete Mulde und eine Vielzahl von in ein oder auch in zwei peripheren Reihen auf der Unterseite angeordneten Polymerhöckern. Der auf der Oberseite in der Mulde angeordnete Chip wird über feine Kontaktierdrähte mit zugeordneten, streifenförmig nach außen führenden Leiterbahnen verbunden. Diese Leiterbahnen sind dann über im äußeren Bereich angeordneten Durchkontaktierungen mit den zugeordneten, oberflächlich metallisierten Polymerhöckern elektrisch leitend verbunden. Werden dann die Randbereiche des Substrats mit mittig durch die Durchkontaktierungslöcher gehenden Schnittlinien abgetrennt, so entstehen elektrisch leitende Querverbindungen mit halbrundem Querschnitt, welche die äußeren Enden der auf der Oberfläche des Substrats angeordneten Leiterbahnen mit den zugeordneten auf der Unterseite des Substrats angeordneten Polymerhöckern elektrisch leitend verbinden.

Aus R. C. ANDERSON et al.:"Printed circuit boards with multiconductor through-holes", TECHNICCAL DIGEST - WESTERN ELECTRIC, Nr. 41, Januar 1976, Seiten 1-2, sind Substrate mit Durchkontaktierungslöchern bekannt, die eine dachförmige oder konvexe Kontur aufweisen. Bei der fotolihtografischen Herstellung der Leiterbahnen auf der Oberseite und der Unterseite des Substrats werden im gleichen Arbeitsgang im Bereich der Durchkontaktierungslöcher gegebenenfalls auch mehrere leiterbahnförmige Querverbindungen erzeugt, die einander zugeordnete Leiterbahnen auf der Oberseite und der Unterseite des Substrats miteinander verbinden.

Der in den Ansprüchen 1 und 9 angegebenen Erfindung liegt das Problem zugrunde, bei der MID-Technologie die Herstellung von elektrisch leitenden Querverbindungen zwischen Leiterstrukturen auf der Oberseite und auf der Unterseite eines Substrats zu vereinfachen. Die Querverbindungen sollen dabei insbesondere auch für die vorstehend erläuterten Polymer Stud Grid Arrays geeignet sein.

Der Erfindung liegt die Erkenntnis zugrunde, daß Querverbindungen gleichzeitig mit der Laserstrukturierung der Leiterstrukturen hergestellt werden können, sofern die Querverbindungen an mindestens einer Stirnseite des Substrats an Kanten mit einer'schrägen, dachförmigen oder konvexen Kontur erzeugt werden. Die Strukturierung der erfindungsgemäßen Querverbindungen kann mit minimalem Aufwand durchgeführt werden, da kein zusätzlicher Arbeitsgang erforderlich ist.

Vorteilhafte Ausgestaltungen des erfindungsgemäßen Verfahrens sind in den Ansprüchen 2 bis 8 angegeben.

Vorteilhafte Ausgestaltungen der erfindungsgemäßen Verdrahtung sind in den Ansprüchen 10 bis 12 angegeben.

Die Ausgestaltung nach Anspruch 2 ermöglicht eine einfache und insbesondere für eine Massenfertigung geeignete Herstellung des Substrats durch Spritzgießen.

Die in den Ansprüchen 3 und 10 angegebenen Konturen erleichtern im Gegensatz zu einer konvexen Kontur durch ihre ausgeprägten Kanten die Laserstrukturierung der Querverbindungen. Gemäß den Ansprüchen 4 und 11 wird dabei durch Neigungswinkel von mindestens 110° zur Horizontalen bzw. von mindestens 20° zur Vertikalen eine effektive Laserstrukturierung der Querverbindungen gewährleistet.

Die Ausgestaltung nach Anspruch 5 ermöglicht eine Realisierung der erfindungsgemäßen Querverbindungen bei Polymer Stud Grid Arrays.

Die Weiterbildung nach Anspruch 6 hat den Vorteil, daß beim Aufbringen der Metallisierung auf Technologien zurückgegriffen werden kann, die sich bei der Herstellung gedruckter Schaltungen seit langer Zeit bewährt haben.

Obwohl das erfindungsgemäße Verfahren prinzipiell auch in Semiadditivtechnik durchgeführt werden kann, bietet die Subtraktivtechnik gemäß Anspruch 7 etliche Vorteile. Neben der einfachen und wirtschaftlichen Erzeugung der gewünschten Leitermuster ist hier insbesondere die einfache Laserstrukturierung eines Ätzresists hervorzuheben. Gemäß Anspruch 8 kann das Ätzresist hierbei besonders einfach durch chemische oder galvanische Abscheidung von Zinn- oder Blei aufgebracht werden.

Gemäß Anspruch 12 sind die erfindungsgemäßen Querverbindungen vorzugsweise bei einem Polymer Stud Grid Array mit einem auf der Oberseite des Substrats angeordneten Chip anwendbar. Durch die Anordnung des Chips auf der Oberseite des Substrats und durch die Anordnung der Polymerhöcker auf der Unterseite des Substrats ergeben sich hier ideale Voraussetzungen für die Realisierung von sog. Chip Scale Packages, bei welchen die Abmessungen des Arrays im wesentlichen den Abmessungen des Chips entsprechen.

Ausführungsbeispiele der Erfindung sind in der Zeichnung dargestellt und werden im folgenden näher beschrieben.

Es zeigen
- Figur 1: einen Querschnitt durch ein Substrat mit einer dachförmigen Kontur der für Querverbindungen relevanten Kanten,
- Figur 2: einen Querschnitt durch ein Substrat mit einer schrägen Kontur der für Querverbindungen relevanten Kanten,
- Figur 3: einen Querschnitt durch ein Substrat mit einer konvexen Kontur der für Querverbindungen relevanten Kanten,
- Figur 4: das Substrat gemäß Figur 1 nach dem Aufbringen einer Metallisierung,
- Figur 5: das Substrat gemäß Figur 4 nach dem Aufbringen eines Ätzresists,
- Figur 6: einen Querschnitt durch eine dachförmige Kontur des Substrats gemäß der Linie VI-VI der Figur 5,
- Figur 7: die Laserstrukturierung der Ätzresistschicht bei dem Querschnitt der dachförmigen Kontur gemäß Figur 6,
- Figur 8: die Ausbildung der Querverbindungen bei dem Querschnitt der dachförmigen Kontur gemäß Figur 6,
- Figur 9: eine teilweise Draufsicht auf die Oberseite des Substrats mit Leiterbahnen und Querverbindungen,
- Figur 10: eine teilweise Draufsicht auf die Unterseite des Substrats mit Leiterbahnen und Querverbindungen und
- Figur 11: eine Seitenansicht des als Polymer Stud Grid Array ausgebildeten Substrats.

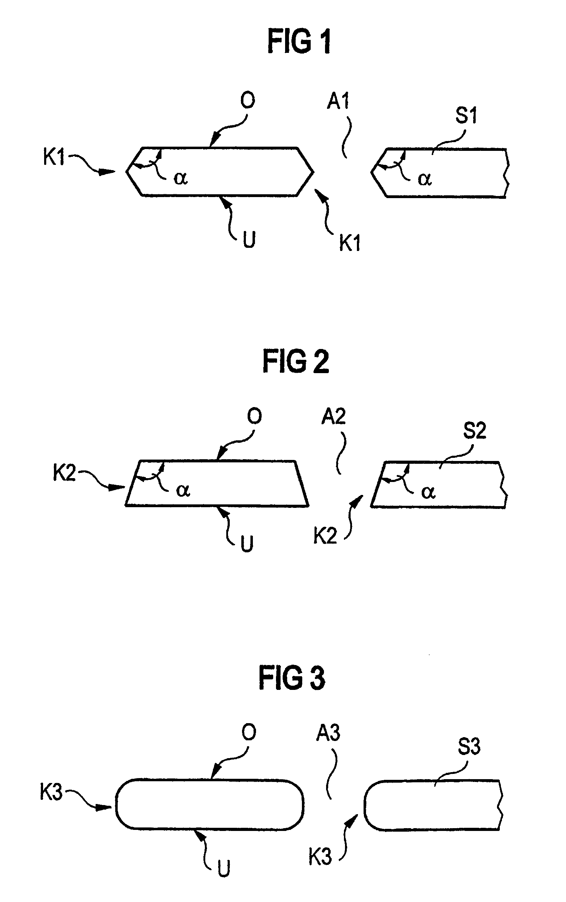

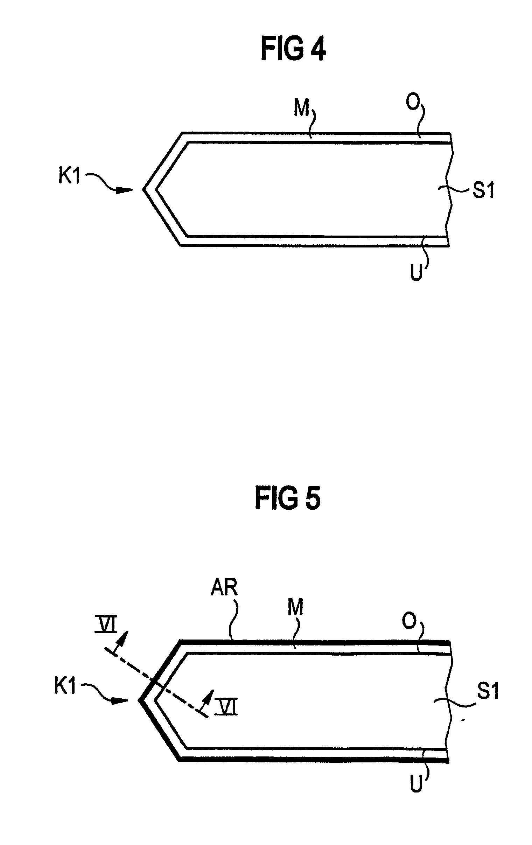

Figur 1 zeigt einen abgebrochen dargestellten Querschnitt durch ein Substrat S1, dessen erkennbare Stirnseite eine dachförmige Kontur K1 besitzt. Im Bereich einer Aussparung A1 des Substrats S1 die eine kreisrunde, ovale, rechteckige oder quadratische Form aufweisen kann, weist die Innenwandung ebenfalls eine dachförmige Kontur K1 auf. Ober- und Unterseite des Substrats S1 sind mit O bzw. U bezeichnet. Die dargestellte dachförmige Kontur K1 ist für die anhand der Figuren 4 bis 10 noch zu erläuternde Herstellung von Querverbindungen vorgesehen. Der Neigungswinkel zwischen der dachförmigen Kontur K1 und der Oberseite O bzw. Unterseite U ist mit α bezeichnet, wobei α größer als 90° ist.

Die Herstellung des Substrats S1 einschließlich der Aussparung A1 und der dachförmigen Konturen K1 erfolgt durch Spritzgießen, wobei als Substratmaterialien hochtemperaturbeständige Thermoplaste wie Polyetherimid, Polyethersulfon oder Polyamid geeignet sind.

Figur 2 zeigt einen abgebrochen dargestellten Querschnitt durch ein Substrat S2, das im Unterschied zu dem in Figur 1 dargestellten Substrat eine schräge Kontur K2 im Bereich einer Stirnseite und im Bereich einer Aussparung A2 besitzt. Der Neigungswinkel zwischen der schrägen Kontur K2 und der Oberseite O des Substrats S2 ist wieder mit α bezeichnet, wobei auch hier α größer als 90° ist.

Figur 3 zeigt einen abgebrochen dargestellten Querschnitt durch ein Substrat S3, das im Unterschied zu dem in den Figuren 1 und 2 dargestellten Substraten eine konvexe Kontur K3 im Bereich einer Stirnseite und im Bereich einer Aussparung A3 besitzt.

Die in den Figuren 1 und 3 dargestellten Substrate S1, S2 und S3 ermöglichen durch ihre speziellen Konturen K1, K2 und K3 eine Laserstrukturierung von dort aufgebrachten Metallisierungen. Im Falle der Konturen K1 und K3 wird diese Laserstrukturierung zur Bildung von Querverbindungen von der Oberseite O und von der Unterseite U her durchgeführt. Im Falle der Kontur K2 wird die Laserstrukturierung von Querverbindungen nur von der Oberseite O her durchgeführt. Abweichend von dem in Figur 1 dargestellten Ausführungsbeispiel kann die dachförmige Kontur K1 auch eine asymmetrische Dachform aufweisen.

Das in Figur 1 dargestellte Substrat S1 wird zunächst einer Reihe von üblichen Vorbehandlungen unterzogen, insbesondere Beizen, Reinigen, Bekeimen und Aktivieren der Bekeimung. Anschließend wird gemäß Figur 4 durch stromlose Kupferabscheidung und nachfolgende galvanische Kupferabscheidung eine Metallisierung M ganzflächig auf das Substrat S1 aufgebracht.

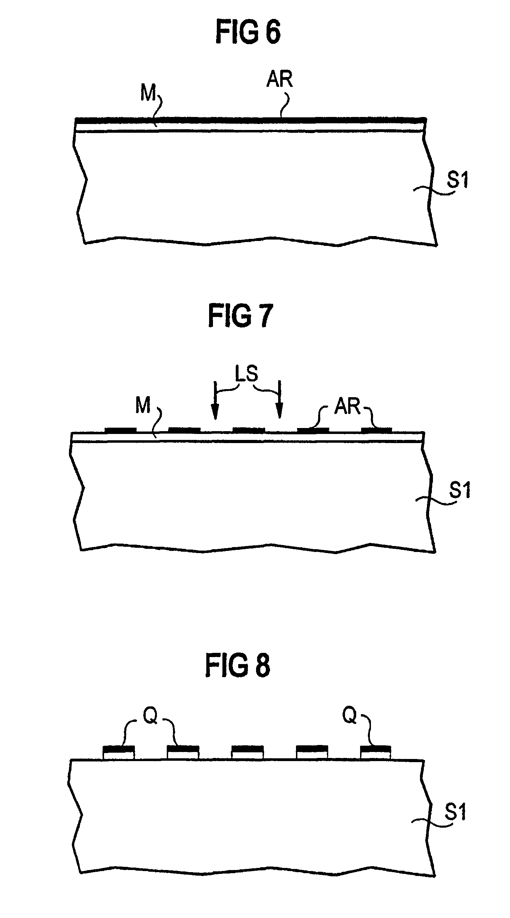

Gemäß Figur 5 wird anschließend durch stromlose oder durch galvanische Abscheidung von Zinn ein Ätzresist AR auf die Metallisierung M aufgebracht.

Figur 6 zeigt einen abgebrochen dargestellten Querschnitt durch die dachförmige Kontur K1 des Substrats S1 gemäß der Linie VI-VI der Figur 5.

Gemäß Figur 7 wird das Ätzresist AR durch Strukturierung mittels eines Laserstrahls LS in denjenigen Bereichen der dachförmigen Kontur K1 (vgl. Figur 5) wieder entfernt, die nicht den späteren Querverbindungen entsprechen. Der Laserstrahl LS ist dabei nicht senkrecht zur Oberfläche der dachförmigen Kontur K1, sondern senkrecht zur Oberfläche O des Substrats S1 ausgerichtet (vgl. Figur 5). Die durch die Laserstrukturierung des Ätzresists AR freigelegten Bereiche der Metallisierung M werden dann gemäß Figur 8 bis zur Oberfläche des Substrats S1 abgeätzt, wobei leiterbahnförmige Querverbindungen Q entstehen.

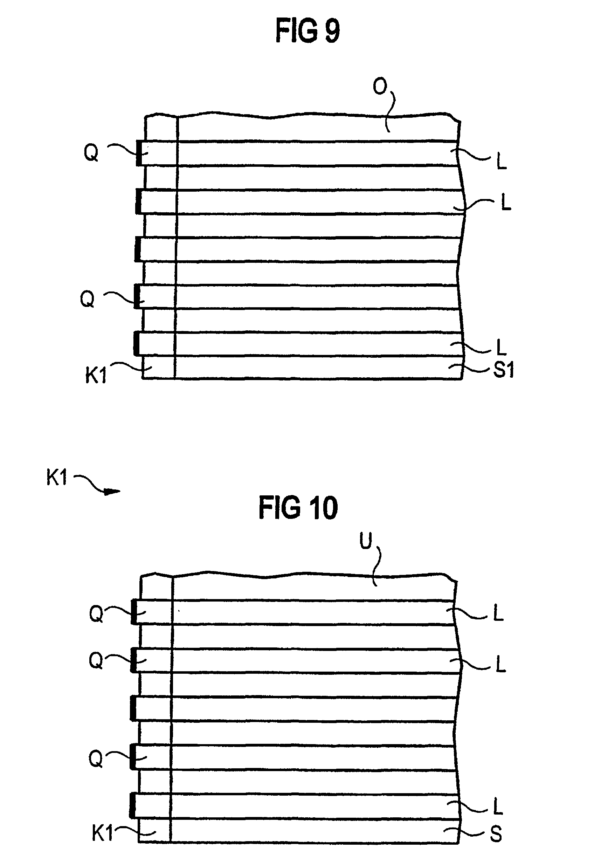

Figur 9 zeigt eine teilweise Draufsicht auf die Oberseite O des Substrats S1 und die darauf ausgebildeten Leiterbahnen L, die fluchtend in die zugeordneten Querverbindungen Q im Bereich der dachförmigen Kontur K1 übergehen. Die Herstellung der Leiterbahnen L auf der Oberseite O des Substrats S1 erfolgt gleichzeitig mit der aus Figur 7 ersichtlichen Herstellung der angrenzenden Querverbindungen Q durch Laserstrukturieren des Ätzresists AR und nachfolgendes Abätzen der freiliegenden Bereiche der Metallisierung M.

Entsprechend der Figur 9 zeigt Figur 10 eine teilweise Draufsicht auf die Unterseite U des Substrats S1 und die darauf ausgebildeten Leiterbahnen L, die fluchtend in die zugeordneten Querverbindungen Q im Bereich der dachförmigen Kontur K1 übergehen. Die Herstellung der Leiterbahnen L auf der Unterseite U des Substrats S1 erfolgt gleichzeitig mit der Herstellung der angrenzenden Verbindungen Q durch Laserstrukturieren des Ätzresists AR und nachfolgendes Abätzen der freiliegenden Bereiche der Metallisierung M. Die Laserstrukturierung wird hierdurch mit einem senkrecht zur Unterseite U des Substrats S1 ausgerichteten Laserstrahl LS (vgl. Figur 7) vorgenommen.

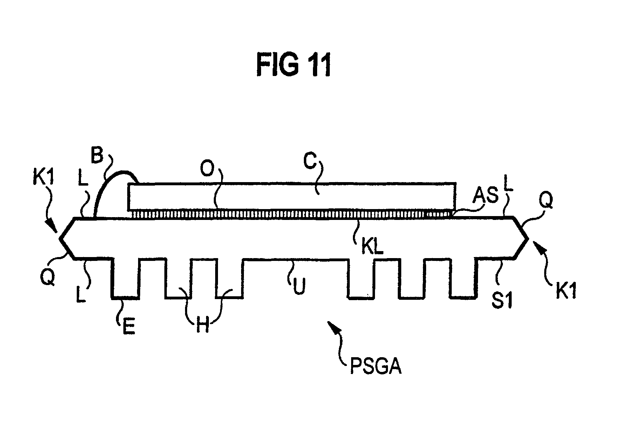

Figur 11 zeigt eine Seitenansicht des Substrats S1 mit Leiterbahnen L, Querverbindungen Q im Bereich der dachförmigen Kontur K1 und mit den bereits erwähnten Polymerhöckern H, die auf der Unterseite U flächig angeordnet sind. Auf die Oberseite O des Substrats S1 ist ein Chip C aufgebracht, dessen Kontaktierung entweder in der links dargestellten Wire-Bond-Technik mit Bonddrähten B oder in der rechts dargestellten Flip-Chip-Technik mit Anschlüssen AS erfolgt.

Bei der Wire-Bond-Technik ist der Chip C über eine Klebschicht KL mit der Oberseite O des Substrats S verbunden.

Figur 11 zeigt deutlich, daß die einzelnen Anschlüsse des Chips C über Leiterbahnen L auf der Oberseite O über stirnseitige Querverbindungen Q im Bereich der dachförmigen Kontur K1 und über Leiterbahnen L auf der Unterseite U mit zugeordneten Polymerhöckern H elektrisch leitend verbunden sind. Auf die Unterseite der metallisierten Polymerhöcker H ist eine lötbare Endoberfläche aufgebracht, die beispielsweise durch eine Schichtenfolge von Nickel und Gold gebildet wird.

Bei dem in Figur 11 dargestellten Gebilde handelt es sich um ein Polymer Stud Grid Array, das insgesamt mit PSGA bezeichnet ist. Weitere Einzelheiten derartiger Polymer Stud Grid Arrays gehen beispielsweise aus der WO-A 96 09 646 hervor.

Bei dem Polymer Stid Grid Array PSGA gemäß Figur 11 sind die Außenabmessungen von Chip C und Substrat S1 etwa gleich groß. Es handelt sich somit um eine Gehäuseform, die üblicherweise als Chip Scale Package bezeichnet wird. Es ist auch klar zu erkennen, daß die stirnseitigen Querverbindungen Q im Bereich der dachförmigen Kontur K1 mit ihrer hohen Strukturfeinheit eine äußerst kompakte Ausgestaltung des gesamten Polymer Stud Grid Arrays PSGA ermöglichen und damit einen entscheidenden Anteil an der Realisierung des Chip Scale Package haben.

## Patentansprüche

1. Verfahren zur Herstellung von Verdrahtungen mit elektrisch leitenden Querverbindungen (Q) zwischen Leiterstrukturen auf der Oberseite (O) und auf der Unterseite (U) eines Substrats (S1; S2; S3), mit folgenden Schritten:
a) Herstellung des Substrats (S1;S2;S3) aus einem elektrisch isolierenden Kunststoff durch Spritzgießen, Spritzpressen oder Formpressen, wobei wenigstens eine Stirnseite des Substrats (S1;S2;S3) eine schräge, dachförmige oder konvexe Kontur (K1;K2;K3) erhält;
b) Aufbringen einer Metallisierung (M) auf das Substrat (S1;S2;S3);
c) Partielle Entfernung der Metallisierung (M) durch Strukturierung mittels eines Laserstrahls (LS) zur Bildung der Leiterstrukturen auf der Oberseite (O) und auf der Unterseite (U) des Substrats (S1;S2;S3) und zur Bildung von leiterbahnförmigen Querverbindungen (Q) im Bereich der oben genannten Kontur von mindestens einer Stirnseite des Substrats (S1;S2;S3).

2. Verfahren nach Anspruch 1,
**dadurch gekennzeichnet, daß** das Substrat (S1;S2;S3) durch Spritzgießen hergestellt wird.

3. Verfahren nach Anspruch 1 oder 2,
**dadurch gekennzeichnet, daß** wenigstens eine Stirnseite des Substrats (S1;S2) eine schräge oder dachförmige Kontur (K1;K2) erhält.

4. Verfahren nach Anspruch 3, **dadurch gekennzeichnet, daß** die Stirnseite zur Oberseite (O) oder zur Unterseite (U) des Substrats (S1; S2) um einen Winkel (α) von mindestens 110° geneigt ist.

5. Verfahren nach einem der vorhergehenden Ansprüche,
**dadurch gekennzeichnet, daß** im Schritt a) bei der Herstellung des Substrats (S1) auf dessen Unterseite (U) flächig angeordnete Polymerhöcker (H) mitgeformt werden und daß nach dem Aufbringen der Metallisierung (M) eine lötbare Endoberfläche (E) auf die Polymerhöcker (H) aufgebracht wird.

6. Verfahren nach einem der vorhergehenden Ansprüche,
**dadurch gekennzeichnet, daß** die Metallisierung (M) durch stromlose und galvanische Abscheidung von Kupfer auf das Substrat (S1) aufgebracht wird.

7. Verfahren nach einem der vorhergehenden Ansprüche,
**dadurch gekennzeichnet, daß** nach dem Schritt b) ein Ätzresist (AR) auf die Metallisierung (M) aufgebracht wird, daß das Ätzresist (AR) durch Strukturierung mittels eines Laserstrahls (LS) in nicht dem gewünschten Leitermuster entsprechenden Bereichen wieder entfernt wird und daß dann die freiliegenden Bereiche der Metallisierung (M) bis zur Oberfläche des Substrats (S1) abgeätzt werden.

8. Verfahren nach Anspruch 7,
**dadurch gekennzeichnet, daß** das Ätzresist (AR) durch galvanische Abscheidung von Zinn oder Zinn-Blei aufgebracht wird.

9. Verdrahtung auf einem Substrat (S1; S2; S3) mit elektrisch leitenden Querverbindungen (Q) zwischen Leiterstrukturen auf der Oberseite (O) und auf der Unterseite (U) des Substrats (S1;S2;S3), wobei
- wenigstens eine Stirnseite des Substrats (S1;S2;S3) eine schräge, dachförmige oder konvexe Kontur (K1;K2;K3) aufweist und wobei
- die Querverbindungen (Q) leiterbahnförmig ausgebildet und im Bereich der oben genannten Kontur von mindestens einer Stirnseite des Substrats (S1;S2;S3) angeordnet sind.

10. Verdrahtung nach Anspruch 9,
**dadurch gekennzeichnet, daß** wenigstens eine Stirnseite des Substrats (S1;S2) eine schräge oder dachförmige Kontur (K1;K2) aufweist.

11. Verdrahtung nach Anspruch 10,
**dadurch gekennzeichnet, daß** die Stirnseite zur Oberseite (O) oder zur Unterseite (U) des Substrats (S1; S2) um einen Winkel (α) von mindestens 110° geneigt ist.

12. Verdrahtung nach Anspruch 9 oder 10, mit
- auf der Unterseite (U) des Substrats (S1) flächig angeordneten und integral angeformten Polymerhöckern (H),
- einem auf der Oberseite (O) des Substrats (S1) in Wire-Bond-Technik oder in Flip-Chip-Technik angeordneten Chip (C) und mit
- einer auf die Polymerhöcker (H) aufgebrachten lötbaren Endoberfläche(E), wobei
- die lötbare Endoberfläche (E) eines Polymerhöckers (H) jeweils über eine Leiterbahn (L) auf der Unterseite (U) des Substrats (S1), eine Querverbindung (Q) und eine Leiterbahn (L) auf der Oberseite (O) des Substrats (S1) mit einem zugeordneten Anschluß (AS) des Chips (C) elektrisch leitend verbunden ist.

## Claims

1. Method for producing wiring arrangements with electrically conductive cross connections (Q) between conductor structures on the top side (O) and on the underside (U) of a substrate (S1; S2; S3), having the following steps:
a) Production of the substrate (S1; S2; S3) from an electrically insulating plastic by injection moulding, transfer moulding or compression moulding, at least one end of the substrate (S1; S2; S3) acquiring an oblique, roof-shaped or convex contour (K1; K2; K3);
b) application of a metallization layer (M) to the substrate (S1; S2; S3);
c) partial removal of the metallization layer (M) by structuring by means of a laser beam (LS) for the purpose of forming the conductor structures on the top side (O) and on the underside (U) of the substrate (S1; S2; S3) and for the purpose of forming conductor track-type cross connections (Q) in the region of the abovementioned contour of at least one end of the substrate (S1; S2; S3).

2. Method according to Claim 1,
**characterized in that** the substrate (S1; S2; S3) is produced by injection moulding.

3. Method according to Claim 1 or 2,
**characterized in that** at least one end of the substrate (S1; S2) acquires an oblique or roof-shaped contour (K1; K2).

4. Method according to Claim 3, **characterized in that** the end is inclined by an angle (α) of at least 110° with respect to the top side (O) or the underside (U) of the substrate (S1; S2).

5. Method according to one of the preceding claims,
**characterized in that**, in step a), polymer studs (H) which are arranged over the area on the underside (U) of the substrate (S1) are concommitantly formed during the production of said substrate, and **in that**, after the application of the metallization layer (M), a solderable end surface (E) is applied to the polymer studs (H).

6. Method according to one of the preceding claims,
**characterized in that** the metallization layer (M) is applied to the substrate (S1) by electroless- and electrodeposition of copper.

7. Method according to one of the preceding claims,
**characterized in that**, after step b), an etching resist (AR) is applied to the metallization layer (M), **in that** the etching resist (AR) is removed again by structuring by means of a laser beam (LS) in regions not corresponding to the desired conductor pattern, and **in that** the uncovered regions of the metallization layer (M) are then etched away down to the surface of the substrate (S1).

8. Method according to Claim 7,
**characterized in that** the etching resist (AR) is applied by the electrodeposition of tin or tin-lead.

9. Wiring arrangement on a substrate (S1; S2; S3) with electrically conductive cross connections (Q) between conductor structures on the top side (O) and on the underside (U) of a substrate (S1; S2; S3), where
- at least one end of the substrate (S1; S2; S3) has an oblique, roof-shaped or convex contour (K1; K2; K3), and where
- the cross connections (Q) are in the form of conductor tracks and arranged in the region of the abovementioned contour of at least one end of the substrate (S1; S2; S3).

10. Wiring arrangement according to Claim 9,
**characterized in that** at least one end of the substrate (S1; S2) has an oblique or roof-shaped contour (K1; K2).

11. Wiring arrangement according to Claim 10,
**characterized in that** the end is inclined by an angle
(α) of at least 110° with respect to the top side (O) or the underside (U) of the substrate (S1; S2).

12. Wiring arrangement according to Claim 9 or 10, having
- polymer studs (H) which are formed integrally and arranged over the area on the underside (U) of the substrate (S1),
- a chip (C) arranged on the top side (O) of the substrate (S1) using wire bonding technology or using flip-chip technology, and having
- a solderable end surface (E) applied to the polymer studs (H), where
- the solderable end surface (E) of a polymer stud (H) is electrically conductively connected to an assigned connection (AS) of the chip (C) in each case via a conductor track (L) on the underside (U) of the substrate (S1), a cross connection (Q) and a conductor track (L) on the top side (O) of the substrate (S1).

## Revendications

1. Procédé de production de câblage ayant des liaisons (Q) transversales conductrices de l'électricité entre des structures de conducteur sur la face (O) supérieure et sur la face (U) inférieure d'un substrat (S1 ; S2 ; S3) comportant les stades suivants :
a) production du substrat (S1 ; S2 ; S3) en une matière plastique isolante du point de vue électrique par moulage par injection, par moulage par transfert ou par moulage par compression, au moins une face frontale du substrat (S1 ; S2 ; S3) recevant un contour (K1 ; K2 ; K3) incliné, en forme de toit ou convexe ;
b) dépôt d'une métallisation (M) sur le substrat (S1 ; S2 ; S3) ;
c) élimination partielle de la métallisation (M) par structuration au moyen d'un rayonnement (LS) laser pour la formation des structures de conducteur sur la face (O) supérieure et sur la face (U) inférieure du substrat (S1 ; S2 ; S3) et pour la formation de liaisons (Q) transversales, en forme de pistes conductrices, dans la partie du contour, mentionnée ci-dessus, d'au moins une face frontale du substrat (S1; S2 ; S3).

2. Procédé suivant la revendication 1, **caractérisé en ce qu'**il consiste à produire le substrat (S1 ; S2 ; S3) par moulage par injection.

3. Procédé suivant la revendication 1 ou 2, **caractérisé en ce qu'**au moins une face frontale du substrat (S1 ; S2) reçoit un contour (K1 ; K2) incliné ou en forme de toit.

4. Procédé suivant la revendication 3, **caractérisé en ce que** la face frontale est inclinée par rapport à la face (O) supérieure ou par rapport à la face (U) inférieure du substrat (S1 ; S2) d'un angle (α) d'au moins 110°.

5. Procédé suivant l'une des revendications précédentes, **caractérisé en ce qu'**au stade a) on forme, lors de la production du substrat (S1) sur sa face (U) inférieure, en même temps des bossages (H) en polymère disposés en surface et **en ce qu'**après le dépôt de la métallisation (M) on dépose sur les bossages (H) en polymère une surface (E) d'extrémité qui peut être brasée.

6. Procédé suivant l'une des revendications précédentes, **caractérisé en ce qu'**il consiste à déposer la métallisation (M) par dépôt sans mise en oeuvre de courant ou par dépôt par électrolyse de cuivre sur le substrat (S1).

7. Procédé suivant l'une des revendications précédentes, **caractérisé en ce qu'**il consiste après le stade b) à déposer un résist (AR) d'attaque chimique sur la métallisation (M), à éliminer à nouveau le résist (AR) d'attaque chimique par structuration au moyen d'un rayonnement (LS) laser dans les parties qui ne correspondent pas au modèle de conducteur souhaité et à enlever par attaque chimique ensuite les parties mises à nu de la métallisation (M) jusqu'à la surface du substrat (S1).

8. Procédé suivant la revendication 7, **caractérisé en ce qu'**il consiste à déposer le résist (AR) d'attaque chimique par dépôt par électrolyse d'étain ou d'étain-plomb.

9. Câblage sur un substrat (S1 ; S2 ; S3) ayant des liaisons (Q) transversales conductrices de l'électricité entre des structures conductrices sur la face (O) supérieure et sur la face (U) inférieure du substrat (S1 ; S2 ; S3), dans lequel
- au moins une face frontale du substrat (S1 ; S2 ; S3) a un contour (K1 ; K2 ; K3) incliné, en forme de toit ou convexe et dans lequel
- les liaisons (Q) transversales sont constituées sous la forme de pistes conductrices et sont disposées dans la partie du contour, mentionnée ci-dessus, d'au moins une surface frontale du substrat (S1 ; S2 ; S3).

10. Câblage suivant la revendication 9, **caractérisé en ce qu'**au moins une face frontale du substrat (S1 ; S2) reçoit un contour (K1 ; K2) incliné ou en forme de toit.

11. Câblage suivant la revendication 10, **caractérisé en ce que** la face frontale est inclinée par rapport à la face (O) supérieure ou par rapport à la face (U) inférieure du substrat (S1 ; S2) d'un angle (α) d'au moins 110°.

12. Câblage suivant la revendication 9 ou 10, comprenant
- des bossages (H) en polymère, disposés à la surface de la face (U) inférieure du substrat (S1) et d'un seul tenant avec lui,
- une puce (C) disposée sur la face (O) supérieure du substrat (1) suivant une technique de liaison par fil ou suivant une technique flip-chip et
- une surface (E) d'extrémité, qui peut être brasée et qui est déposée sur les bossages (H) en polymère, dans lequel
- la surface (E) d'extrémité, qui peut être brasée, d'un bossage (H) en polymère est reliée d'une manière conductrice de l'électricité respectivement par une piste (L) conductrice sur la face (U) inférieure du substrat (S1) par une liaison (Q) transversale et par une piste (L) conductrice sur la face (O) supérieure du substrat (S1) à une borne (AS) associée de la puce (C).
